# EUROPEAN PATENT SPECIFICATION

(11) **EP 3 082 014 B1**
(45) Date of publication and mention of the grant of the patent: **21.02.2018**
(21) Application number: 15163810.3
(22) Date of filing: 16.04.2015
(51) Int. Cl.: G06F 1/32, H03K 17/96, G06F 3/0354

(54) **POWER SAVING CIRCUIT AND ELECTRONIC DEVICE HAVING THE SAME**
STROMSPARSCHALTUNG UND ELEKTRONISCHE VORRICHTUNG DAMIT
CIRCUIT D'ÉCONOMIE D'ÉNERGIE ET DISPOSITIF ÉLECTRONIQUE COMPRENANT CELUI-CI

(43) Date of publication of application: 19.10.2016
(73) Proprietor: Cheng Uei Precision Industry Co., Ltd., New Taipei City 236 (TW)
(72) Inventor: Lin, Sheng-Yuan, 236 New Taipei City (TW); Fan, Duo-Chi, 236 New Taipei City (TW)
(74) Representative: Latzel, Klaus

(56) References cited:
- US-A1- 2014 160 088
- US-B1- 8 773 405
- Michael Hartshorne: "Maximize shelf life with a one-time, push-button switch - Power House - Blogs - TI E2E Community", , 5 June 2014 (2014-06-05), XP055217787, Retrieved from the Internet: URL:http://e2e.ti.com/blogs_/b/powerhouse/ archive/2014/06/05/maximize-shelf-life-wit h-a-one-time-push-button-switch [retrieved on 2015-10-01]

## Description

### BACKGROUND OF THE INVENTION

### 1. Field of the Invention

The present invention relates to a power saving circuit, and more particularly to a power saving circuit and an electronic device having the same which is capable of saving the power consumption of the electronic device through a pressure sensing function.

### 2. The Related Art

Prior art in this technical field is disclosed in documents US 2014/16008 8 A1 or US 8,773,405 B1. A conventional electronic device is still consume a little power in the deep sleep state, because the power supply is supplied to certain parts of the electronic device in order to rapidly awaken the electronic device when reusing the electronic device. The power consumption is still a serious problem to users of the electronic device.

Furthermore, a conventional stylus, capable of detecting pressure on a tip thereof, has a button for turning on the power supply from sleep state. The stylus is a low-power consumption product. If the power consumption of the stylus in the sleep state is removed, the use of time and standby time of the stylus will be increased.

Therefore, there is a need for a power saving circuit and electronic device having the same which can efficiently solve the problem of the power consumption of the electronic device.

### SUMMARY OF THE INVENTION

Accordingly, an object of the present invention is to provide a power saving circuit. The power saving circuit is interposed between a power supply unit and a device circuit. The power saving circuit includes a variable resistor, a switch and a processing module. The power supply unit is connected between the switch and the variable resistor. The processing module is connected between the switch and the variable resistor. The switch connects with the variable resistor. The switch is capable of conducting the power supply unit and the processing module when the variable resistor is pressed. The processing module is capable of transmitting a working signal to the switch for making the switch continuing conducting the power supply unit and the processing module when the variable resistor is unpressurized after the power is transmitted to the processing module, the processing module is capable of detecting the condition of the voltage of the variable resistor to change the working signal. The switch is capable of breaking the power supply of the processing module if the working signal is off state.

As described above, the power saving circuit can efficiently remove the power consumption of an electronic device when the electronic device is in sleep state, therefore, the standby time of the electronic device is increased.

### BRIEF DESCRIPTION OF THE DRAWINGS

The present invention will be apparent to those skilled in the art by reading the following description thereof, with reference to the attached drawings, in which:
FIG. 1 is a block diagram of a power saving circuit in accordance with an embodiment of the present invention;
FIG. 2 is a schematic diagram of a power saving circuit of FIG. 1 in accordance with an embodiment of the present invention;
FIG. 3 is a block diagram of an electronic device having the power saving circuit in accordance with an embodiment of the present invention; and
FIG. 4 is a schematic diagram of a stylus in accordance with another embodiment of the present invention;
FIG. 5 is another schematic diagram of the stylus of FIG. 4.

### DETAILED DESCRIPTION OF THE EMBODIMENT

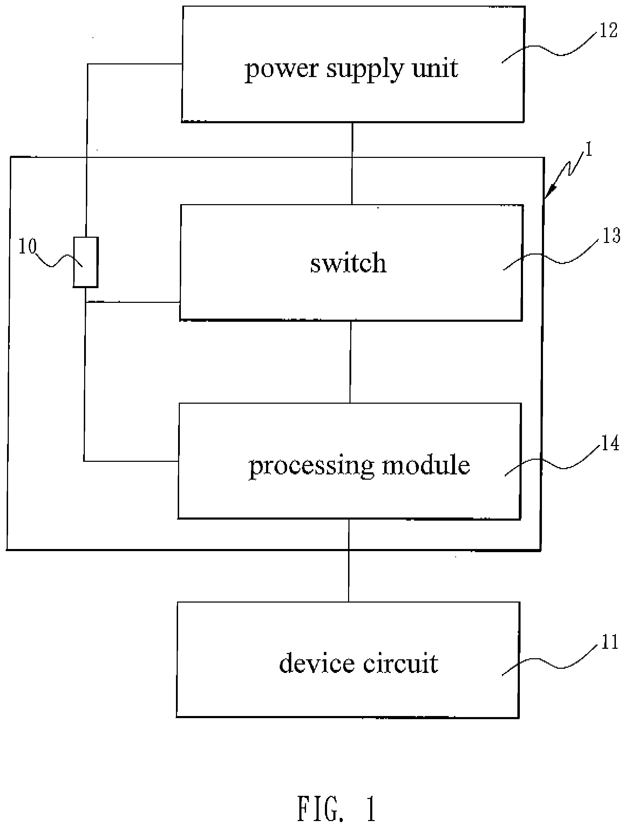

Please refer to FIG. 1, a power saving circuit 1 according to an embodiment of the present invention is interposed between a power supply unit 12 and a device circuit 11. The power supply unit 12 is capable of saving the power consumption of the device circuit 11 through a pressure sensing function.

The power saving circuit 1 includes a variable resistor 10, a switch 13 and a processing module 14. The power supply unit 12 is connected between the switch 13 and the variable resistor 10. The processing module 14 is connected between the switch 13, the variable resistor 10 and the device circuit 11. The switch 13 is connected with the variable resistor 10.

In this embodiment of the power saving circuit 1, the switch 13 is capable of conducting the power supply unit 12 and the processing module 14 when the variable resistor 10 is pressed. The processing module 14 is capable of transmitting a working signal to the switch 13 for making the switch 13 continuing conducting the power supply unit 12 and the processing module 14 when the variable resistor 10 is unpressurized after the power is transmitted to the processing module 14. The processing module 14 is capable of detecting the condition of the voltage of the variable resistor 10 to change the working signal. The switch 13 is capable of breaking the power supply of the processing module 14 if the working signal is off state.

In this embodiment of the power saving circuit 1, the variable resistor 10 is a pressure sensor.

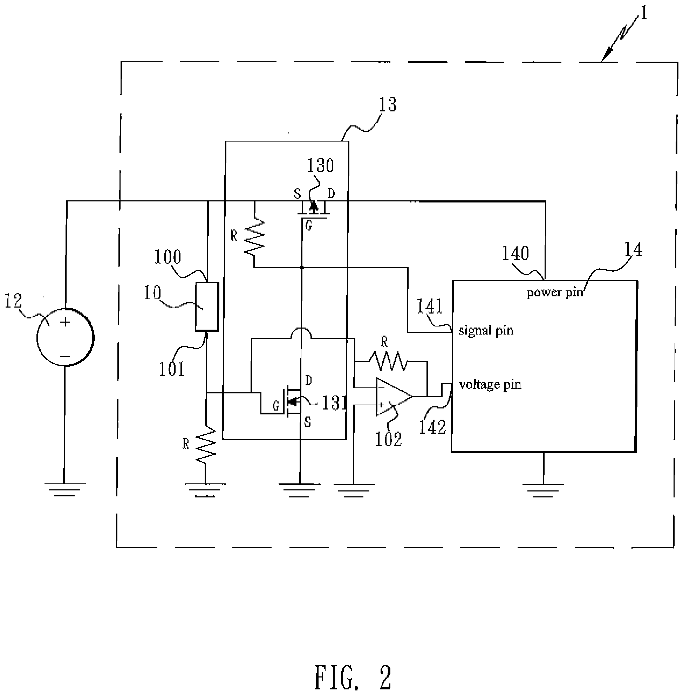

Please refer to FIG. 2, the variable resistor 10 includes a first end 100 and a second end 101, the switch 13 includes a PMOS transistor 130 and a NMOS transistor 131. The processing module 14 includes a power pin 140, a signal pin 141 and a voltage pin 142.

The positive of the power supply unit 12 connects to the source S of the PMOS transistor 130 and the first end 100 of the variable resistor 10. The second end 101 of the variable resistor 10 connects to the gate G of the NMOS transistor 131. The second end 101 of the variable resistor 10 and the gate G of the NMOS transistor 131 are connects to ground potential via a resistor and connects to the voltage pin 142. The source S of the NMOS transistor 131 connects to ground potential. The drain D of the NMOS transistor 131 connects to the gate G of the PMOS transistor 130. The drain D of the PMOS transistor 130 connects to the power pin 140. The positive of the power supply unit 12 and the source S of the PMOS transistor 130 are connected between the gate G of the PMOS transistor 130, the drain D of the NMOS transistor 131 and the signal pin 141 via a resistor.

The second end 101 of the variable resistor 10 and the gate G of the NMOS transistor 131 connects to the voltage pin 142 via an inverting amplifier 102 for amplifying the voltage of the variable resistor 10 and controlling current flow.

When the variable resistor 10 is pressed, the resistance of the variable resistor 10 is smaller because of the pressure, then the current flows to the gate G of the NMOS transistor 131 through the variable resistor 10 that makes the source S of the NMOS transistor 131 and the drain D of the NMOS transistor 131 being conducted. Due to the source S of the NMOS transistor 131 connects to the ground potential, the gate G of the PMOS transistor 130 becomes "low level" that makes the source S of the PMOS transistor 130 and the drain D of the PMOS transistor 130 are conducted, whereupon, the current flows to the power pin 140 through the PMOS transistor 130.

If the processing module 14 receives the current flow, the voltage of the variable resistor 10 would be sensed by the processing module 14. The processing module 14 controls the signal pin 141 become "low level" to make the gate G of the PMOS transistor 130 become low level in order to maintain the source S of the PMOS transistor 130 and the drain D of the PMOS transistor 130 being conducted (at this time, whether the variable resistor 10 is pressed or not, the processing module 14 will continue receiving the power supply).

If the device circuit 11 needs to be turned off, the user can control the processing module 14 to make the signal pin 141 at "high level", whereupon the gate G of the PMOS transistor 130 becomes "high level" and then the source S of the PMOS transistor 130 and the drain D of the PMOS transistor 130 are nonconducted.

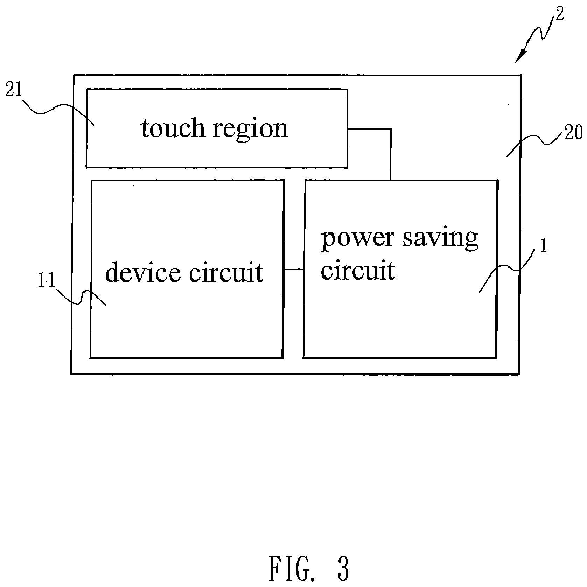

Please refer to FIG. 3, the power saving circuit 1 can be applied to an electronic device 2. The electronic device 2 has a housing 20 defining a touch region 21. The power saving circuit 1 and the device circuit 11 are disposed in the housing 20. The variable resistor 10 is configured to sense touch from the touch region 21. The touch region 21 of the housing 20 is used for contacting an object. The device circuit 11 controls the electronic device 2 according to the voltage of the variable resistor 10.

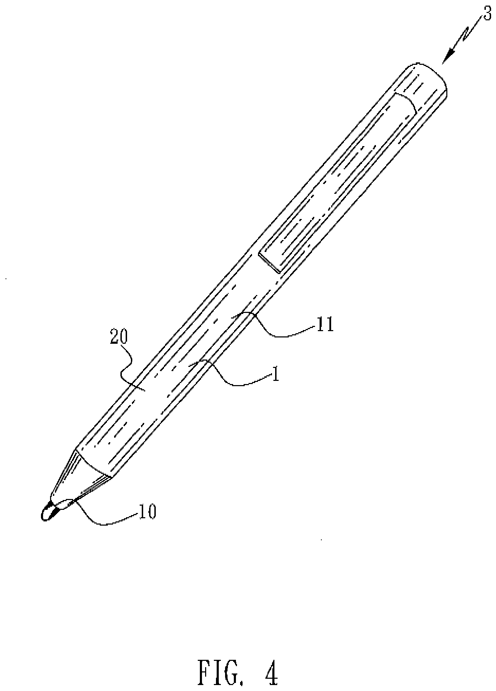

Please refer to FIG. 4, in a further embodiment, the electronic device 2 is a stylus 3. The housing 20 is pen-shape, the variable resistor 10 is disposed in one end of the housing 20. A wireless module 30 connects to the device circuit 11 for communicating with other devices.

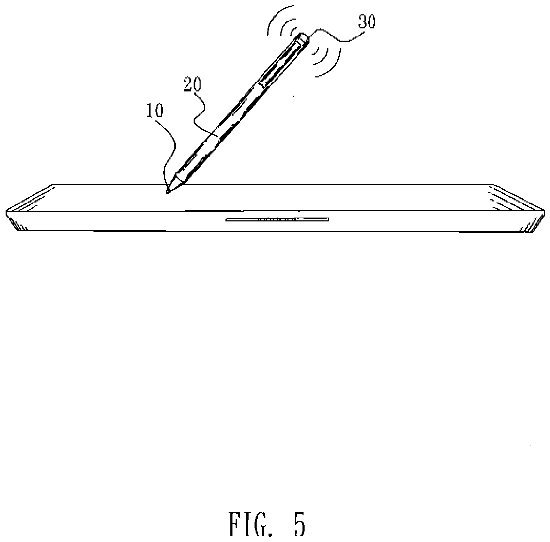

Please refer to FIG. 5, the variable resistor 10 is used to sense the stylus 3 stroke and is used as a button which is pressed when the one end of the housing 20 touches the object.

As described above, the power saving circuit 1 includes the following advantages: first, the power saving circuit 1 can efficiently remove the power consumption of the electronic device 2 when the electronic device 2 is in sleep state, therefore, the standby time of the electronic device 2 is increased.

The foregoing description of the present invention has been presented for the purposes of illustration and description. It is not intended to be exhaustive or to limit the invention to the precise form disclosed, and obviously many modifications and variations are possible in light of the above teaching. The scope of this invention is however defined solely by the accompanying claims.

## Claims

1. A power saving circuit (1) interposed between a power supply unit (12) and a device circuit (11), comprising:
a variable resistor (10), a switch (13) and a processing module (14), the power supply unit (12) connected between the switch (13) and the variable resistor (10), the processing module (14) connected between the switch (13) and the variable resistor (10), the switch (13) connected with the variable resistor (10), the switch (13) capable of conducting the power supply unit (12) and the processing module (14) when the variable resistor (10) is pressed, the processing module (14) capable of transmitting a working signal to the switch (13) for making the switch (13) continuing conducting the power supply unit (12) and the processing module (14) when the variable resistor (10) is unpressurized after the power is transmitted to the processing module (14), the processing module (14) capable of detecting the condition of the voltage of the variable resistor (10) to change the working signal, the switch (13) capable of breaking the power supply of the processing module (14) if the working signal is off state, **characterized in that**:
the variable resistor (10) comprises a first end (100) and a second end (101), the switch (13) comprises a PMOS transistor (130) and a NMOS transistor (131), the processing module (14) comprises a power pin (140), a signal pin (141) and a voltage pin (142), the positive of the power supply unit (12) is connected to the source (S) of the PMOS transistor (130) and the first end (100) of the variable resistor (10), the second end (101) of the variable resistor (10) is connected to the gate (G) of the NMOS transistor (131), the second end (101) of the variable resistor (10) and the gate (G) of the NMOS transistor (131) are connected to ground potential via a resistor and connected to the voltage pin (142), the source (S) of the NMOS transistor (131) is connected to ground potential, the drain (D) of the NMOS transistor (131) is connected to the gate (G) of the PMOS transistor (130), the drain (D) of the PMOS transistor (130) is connected to the power pin (140), the positive of the power supply unit (12) and the source (S) of the PMOS transistor (130) are connected between the gate (G) of the PMOS transistor (130), the drain (D) of the NMOS transistor (131) and the signal pin (141) via a resistor.

2. The power saving circuit according to claim 1, wherein the variable resistor (10) is a pressure sensor.

3. The power saving circuit according to claim 1, wherein the second end (101) of the variable resistor (10) and the gate (G) of the NMOS transistor (131) is connected to the voltage pin (142) via an inverting amplifier (102).

## Patentansprüche

1. Energiesparschaltung (1), die zwischen einem Netzteil (12) und einem Gerätestromkreis (11) zwischengeschaltet ist, umfassend:
einen Regelwiderstand (10), einen Schalter (13) und ein Verarbeitungsmodul (14), wobei das Netzteil (12) zwischen dem Schaler (13) und dem Regelwiderstand (10) geschaltet ist, das Verarbeitungsmodul (14) zwischen dem Schalter (13) und dem Regelwiderstand (10) geschaltet ist und der Schalter (13) mit dem Regelwiderstand (10) geschaltet ist, wobei der Schalter (13) das Netzteil (12) und das Verarbeitungsmodul (14) leitend verbinden kann, falls der Regelwiderstand (10) gedrückt ist, das Verarbeitungsmodul (14) ein Arbeitssignal an den Schalter (13) übermitteln kann, um den Schalter (13) derart auszugestalten, dass er das Netzteil (12) und das Verarbeitungsmodul (14) leitend verbunden halten kann, auch falls der Regelwiderstand (10), nachdem der Strom zu dem Verarbeitungsmodul (14) übermittelt worden war, nicht mehr gedrückt ist, das Verarbeitungsmodul (14) den Spannungszustand des Regelwiderstands (10) zur Veränderung des Arbeitssignals detektieren kann, der Schalter (13) eine Stromversorgung des Verarbeitungsmoduls (14) unterbrechen kann, wenn das Arbeitssignal im Zustand AUS ist, **dadurch gekennzeichnet, dass**:
der Regelwiderstand (10) ein erstes Ende (100) und ein zweites Ende (101) umfasst, der Schalter (13) einen PMOS-Transistor (130) und einen NMOS-Transistor (131) umfasst, das Verarbeitungsmodul (14) einen Stromkontakt (140), einen Signalkontakt (141) und einen Spannungskontakt (142) umfasst, wobei der positive Pol des Netzteils (12) mit der Source (S) des PMOS-Transistors (130) und dem ersten Ende (100) des Regelwiderstands (10) geschaltet ist, das zweite Ende (101) des Regelwiderstands (10) mit dem Gate (G) des NMOS-Transistors (131) geschaltet ist, das zweite Ende (101) des Regelwiderstands (10) und das Gate (G) des NMOS-Transistors (131) über einen Widerstand mit dem Grundpotential geschaltet sind und mit dem Spannungskontakt (142) geschaltet sind, die Source (S) des NMOS-Transistors (131) mit dem Grundpotential geschaltet ist, das Drain (D) des NMOS-Transistors (131) mit dem Gate (G) des PMOS-Transistors (130) geschaltet ist, das Drain (D) des PMOS-Transistors (130) mit dem Stromkontakt (140) geschaltet ist, der positive Pol des Netzteils (12) und die Source (S) des PMOS-Transistors (130) über einen Widerstand zwischen dem Gate (G) des PMOS-Transistors (130), dem Drain (D) des NMOS-Transistors (131) und dem Signalkontakt (141) geschaltet sind.

2. Energiesparschaltung gemäß Anspruch 1, wobei der Regelwiderstand (10) ein Drucksensor ist.

3. Energiesparschaltung gemäß Anspruch 1, wobei das zweite Ende (101) des Regelwiderstands (10) und das Gate (G) des NMOS-Transistors (131) mit dem Spannungskontakt (142) über einen invertierenden Verstärker (102) geschaltet sind.

## Revendications

1. Circuit d'économie d'énergie (1) interposé entre une unité d'alimentation électrique (12) et un circuit de dispositif (11), comprenant :
une résistance variable (10), un commutateur (13) et un module de traitement (14), l'unité d'alimentation électrique (12) étant connectée entre le commutateur (13) et la résistance variable (10), le module de traitement (14) étant connecté entre le commutateur (13) et la résistance variable (10), le commutateur (13) étant connecté à la résistance variable (10), le commutateur (13) étant apte à diriger l'unité d'alimentation électrique (12) et le module de traitement (14) lorsque la résistance variable (10) est pressée, le module de traitement (14) étant apte à émettre un signal de fonctionnement au commutateur (13) pour amener le commutateur (13) à continuer de diriger l'unité d'alimentation électrique (12) et le module de traitement (14) lorsque la résistance variable (10) est non pressée après que la puissance est transmise au module de traitement (14), le module de traitement (14) étant apte à détecter l'état de la tension de la résistance variable (10) pour changer le signal de fonctionnement, le commutateur (13) étant apte à couper l'alimentation électrique du module de traitement (14) si le signal de fonctionnement est à l'état éteint, **caractérisé par le fait que** :
la résistance variable (10) comprend une première borne (100) et une seconde borne (101), le commutateur (13) comprend un transistor PMOS (130) et un transistor NMOS (131), le module de traitement (14) comprend une broche d'alimentation (140), une broche de signal (141) et une broche de tension (142), le positif de l'unité d'alimentation électrique (12) est connecté à la source (S) du transistor PMOS (130) et à la première borne (100) de la résistance variable (10), la seconde borne (101) de la résistance variable (10) est connectée à la grille (G) du transistor NMOS (131), la seconde borne (101) de la résistance variable (10) et la grille (G) du transistor NMOS (131) sont connectées au potentiel de masse par l'intermédiaire d'une résistance et connectées à la broche de tension (142), la source (S) du transistor NMOS (131) est connectée au potentiel de masse, le drain (D) du transistor NMOS (131) est connecté à la grille (G) du transistor PMOS (130), le drain (D) du transistor PMOS (130) est connecté à la broche d'alimentation (140), le positif de l'unité d'alimentation électrique (12) et la source (S) du transistor PMOS (130) sont connectés entre la grille (G) du transistor PMOS (130), le drain (D) du transistor NMOS (131) et la broche de signal (141) par l'intermédiaire d'une résistance.

2. Circuit d'économie d'énergie selon la revendication 1, dans lequel la résistance variable (10) est un capteur de pression.

3. Circuit d'économie d'énergie selon la revendication 1, dans lequel la seconde borne (101) de la résistance variable (10) et la grille (G) du transistor NMOS (131) sont connectées à la broche de tension (142) par l'intermédiaire d'un amplificateur inverseur (102).
